(19) **Europäisches Patentamt / European Patent Office / Office européen des brevets**

(11) **EP 3 584 900 A1**

(12) # EUROPÄISCHE PATENTANMELDUNG

(43) Veröffentlichungstag:
**25.12.2019  Patentblatt 2019/52**

(51) Int Cl.:
*H02H 3/16* (2006.01)     *G01R 27/18* (2006.01)
*G01R 31/02* (2006.01)

(21) Anmeldenummer: **18178800.1**

(22) Anmeldetag: **20.06.2018**

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**
Benannte Erstreckungsstaaten:
**BA ME**
Benannte Validierungsstaaten:
**KH MA MD TN**

(71) Anmelder: **Siemens Aktiengesellschaft**
**80333 München (DE)**

(72) Erfinder:
• **Behringer, Klaus**
**91338 Igensdorf (DE)**
• **Meier, Matthias**
**92284 Poppenricht (DE)**

(54) **VORRICHTUNG ZUR ERDSCHLUSSÜBERWACHUNG IN EINEM GLEICHSTROMNETZ**

(57)     Die Erfindung beschreibt eine Vorrichtung zur Erdschlussüberwachung in einem Gleichstromnetz, wobei das Gleichstromnetz eine zwischen einer ersten Phase (PP) mit positivem Spannungspotential und einer zweiten Phase (PM) mit negativem Spannungspotential verschaltete Gleichspannungsquelle (SPQ) umfasst. Die erste Phase (PP) ist über einen ersten Widerstand ($R_2$) und die zweite Phase (PM) ist über einen zweiten Widerstand ($R_3$) mit einem mit Bezugspotential beaufschlagten ersten Sternpunkt (SP1) verbunden. Zwischen der ersten Phase (PP) und der zweiten Phase (PM) ist zumindest eine Wechsel- oder Drehstrom verarbeitende Verbrauchsanordnung (WR, V) verschaltet. Die erfindungsgemäße Vorrichtung umfasst eine Messvorrichtung (MV), die dazu ausgebildet ist, einen statischen Erdschluss zwischen einer der Phasen (PP, PM) und dem Bezugspotential und/oder einen dynamischen Erdschluss zwischen einer mit Wechsel oder Drehstrom beaufschlagten Phase (L1, L2, L3) der Verbrauchsanordnung (WR, V) und dem Bezugspotential zu detektieren durch Messung der über dem ersten und dem zweiten Widerstand ($R_2$, $R_3$) abfallenden Spannung und Auswertung einer Spannungsverteilung über dem ersten und dem zweiten Widerstand ($R_2$, $R_3$).

FIG 2

EP 3 584 900 A1

**Beschreibung**

Die Erfindung betrifft eine Vorrichtung und ein Verfahren zur Erdschlussüberwachung in einem Gleichstromnetz. Das Gleichstromnetz umfasst eine zwischen einer ersten Phase mit positivem Spannungspotential und einer zweiten Phase mit negativem Spannungspotential verschaltete Gleichspannungsquelle. Dabei ist die erste Phase über einen ersten Widerstand und die zweite Phase über einen zweiten Widerstand mit einem mit Bezugspotential, z.B. Erdpotential, beaufschlagten ersten Sternpunkt verbunden. Zwischen der ersten Phase und der zweiten Phase ist ferner zumindest eine Wechselstrom verarbeitende Verbrauchsanordnung verschaltet, wie z.B. ein Wechselrichter mit einem daran angeschlossenen Wechsel- oder Drehstromverbraucher, wie z.B. ein Motor.

Es gibt Überlegungen, die Stromversorgung industrieller Anlagen mit einem Gleichstromnetz zu realisieren. Ein aus einem Gleichstromnetz mit Energie versorgter Verbraucher führt im Rahmen industrieller Anlagen und damit verbundener Produktionsprozessese zu zahlreichen Vorteilen. Durch eine intelligente Steuerung des Gleichstromnetzes und die Möglichkeit, erneuerbare Energieerzeuger sowie Energiespeicher zu integrieren, kann flexibel und robust auf schwankende Netzqualität und Energieangebote reagiert werden. Energieeinsparungen ergeben sich unter anderem durch die einfachere Nutzung und Pufferung, z.B. von Bremsenergie, welche durch das sog. generatorische Bremsen elektrischer Antriebe möglich ist. Ein großer Vorteil besteht auch darin, dass Wandlungsverluste von Wechsel- in Gleichspannung, oder umgekehrt, reduziert werden können. Die Stromversorgung industrieller Anlagen mit Hilfe von Gleichstromnetzen ermöglicht im Ergebnis eine Effizienzerhöhung.

Auch bei Gleichstromnetzen in industriellen Anlagen müssen bei der Auslegung mögliche Fehlerfälle berücksichtigt werden. So können auch in einem Gleichstromnetz beispielsweise Erdschlüsse auftreten. Ein Erdschluss kann direkt in der Verteilung des Gleichstromnetzes oder in den nachgeschalteten Verbrauchern auftreten. Diese Fehler müssen erfasst, behandelt und an eine zentrale Steuerung des Gleichstromnetzes gemeldet werden.

Ein Gleichstromnetz, bei dem eine erste Phase mit positivem Spannungspotential über einen ersten Widerstand mit einem mit Bezugspotential beaufschlagten ersten Sternpunkt verbunden ist und bei dem eine zweite Phase mit negativem Spannungspotential über einen zweiten Widerstand mit dem mit Bezugspotential beaufschlagten ersten Sternpunkt verbunden ist, erzeugt durch die definierten Impedanzen zum Bezugspotential ein definiertes Spannungsverhältnis der ersten und der zweiten Phase zum Bezugspotential. Erdschlüsse, die zwischen der ersten oder der zweiten Phase und dem Bezugspotential auftreten, werden als statische Erdschlüsse bezeichnet.

Erdschlüsse, welche beispielsweise von einem Wechselstromverbraucher zu dem Bezugspotential auftreten, werden im Folgenden als dynamische Erdschlüsse bezeichnet. In Wechselstromnetzen erfolgt eine Fehlerstromüberwachung, indem die aus dem Wechselstromnetz fließenden Ströme aller Phasen gemessen werden. Alternativ kann eine sog. "Ground Fault"-Überwachung über die Summenströme der verschiedenen Phasen realisiert werden. Die Überwachung von Erdschlüssen in Gleichstromnetzen erfordert eine sog. Allphasen-sensitive Messung, welche in einem Gleichstromnetz jedoch nur schwierig zu realisieren ist.

Es besteht daher die Notwendigkeit, eine Vorrichtung und ein Verfahren anzugeben, welche es in einem Gleichstromnetz ermöglichen, sowohl statische als auch dynamische Erdschlüsse zu überwachen.

Diese Aufgabe wird gelöst durch eine Vorrichtung gemäß den Merkmalen des Patentanspruches 1. Vorteilhafte Ausgestaltungen ergeben sich aus den abhängigen Patentansprüchen. Dabei kann das erfindungsgemäße Verfahren auch entsprechend den abhängigen Vorrichtungsansprüchen weitergebildet sein, und umgekehrt.

Es wird eine Vorrichtung zur Erdschlussüberwachung in einem Gleichstromnetz vorgeschlagen. Das Gleichstromnetz umfasst eine zwischen einer ersten Phase mit positivem Spannungspotential und einer zweiten Phase mit negativem Spannungspotential verschaltete Gleichspannungsquelle. Die erste Phase ist über einen ersten Widerstand und die zweite Phase ist über einen zweiten Widerstand mit einem mit Bezugspotential beaufschlagten ersten Sternpunkt verbunden. Das Verhältnis des Widerstandswerts des ersten Widerstands zu dem Widerstandswert des zweiten Widerstandes ist dabei definiert und bekannt. Zwischen der ersten Phase und der zweiten Phase ist zumindest eine Wechselstrom verarbeitende Verbrauchsanordnung verschaltet. Das Bezugspotential ist z.B. Erdpotential.

Die Vorrichtung umfasst eine Messvorrichtung. Die Messvorrichtung ist dazu ausgebildet, einen statischen Erdschluss zwischen einer der Phasen und dem Bezugspotential und/oder einen dynamischen Erdschluss zwischen einer mit Wechselstrom beaufschlagten Phase der Verbrauchsanordnung und dem Bezugspotential zu detektieren durch Messung der über den ersten und den zweiten Widerstand abfallenden Spannung und Auswertung einer Spannungsverteilung über dem ersten und dem zweiten Widerstand.

Dieser Vorrichtung liegt die Erkenntnis zu Grunde, dass sich bei einem Erdschluss zwei unterschiedliche Fehlerbilder ergeben können.

Bei einem statischen Erdschluss verändert sich die über dem ersten und dem zweiten Widerstand abfallende Spannung, wodurch sich das Spannungsverhältnis verschiebt. Das bei einem statischen Erdschluss vorliegende Spannungsverhältnis der ersten und der zweiten Phase zum Bezugspotential ist also verändert im Vergleich zu dem ohne einen statischen Erdschluss vorliegenden Spannungsverhältnis der ersten und der zweiten Phase zum Bezugspotential. Das ohne einen statischen Erdschluss vorliegende Spannungsverhältnis der ersten und der zweiten Phase zum Bezugspotential bildet einen Referenzwert, mit dem die aktuell gemessenen Spannungsverhältnisse verglichen werden. Das Spannungspotential des ersten Sternpunkts verschiebt sich; diese Verschiebung bzw. Veränderung kann durch die Messvorrichtung detektiert werden.

Als weiteres Fehlerbild kann ein dynamischer Erdschluss auftreten, wenn sich z.B. in der Verbrauchsanordnung, die einen Umrichter und einen Wechselstromverbraucher umfassen kann, eine Verfälschung der durch den Umrichter erzeugten sinus- oder halbsinusförmigen Gleichspannung gegenüber dem Bezugspotential ergibt. Diese beiden Fehler können mit Hilfe der Messvorrichtung erfasst werden, indem eine Auswertung der Spannungsverteilung über dem ersten und dem zweiten Widerstand detektiert wird. Dadurch ist sogar eine Klassifikation des Fehlers möglich.

Die Vorrichtung ermöglicht im Ergebnis nicht nur die Detektion von Erdschlüssen in einem Wechselstromnetz, sondern auch in einem Gleichstromnetz. Durch die mit Hilfe der Messvorrichtung vorgenommene kombinatorische Auswertung können dynamische und statische Erdschlüsse erkannt werden.

Werden der erste und der zweite Widerstand gleich groß gewählt, d.h. sind die elektrischen Widerstandswerte des ersten und des zweiten Widerstands, die mit dem ersten Sternpunkt verbunden sind, gleich groß, so sind die über dem ersten und dem zweiten Widerstand abfallenden Spannungen dem Betrag nach gleich groß, wenn kein Fehler, insbesondere kein Erdschluss, vorliegt. Die Ausgestaltung, die Widerstandswerte des ersten und des zweiten Widerstand gleich groß zu wählen, ermöglicht dadurch eine besonders einfache Erkennung eines Erdschlusses.

Gemäß einer bevorzugten Ausgestaltung der Vorrichtung ist die Messvorrichtung dazu ausgebildet, auf einen statischen Erdschluss zu schließen, wenn das Verhältnis der Beträge der über dem ersten und dem zweiten Widerstand abfallenden Spannungen sich zeitlich ändert. In einer besonders zweckmäßigen Ausgestaltung ist vorgesehen, dass die Messvorrichtung dazu ausgebildet ist, auf einen statischen Erdschluss zu schließen, wenn das Verhältnis der Beträge der über dem ersten und dem zweiten Widerstand abfallenden Spannungen von dem korrespondierenden definierten Verhältnis, welches ohne einen statischen Erdschluss vorliegt, abweicht. Dies entspricht der oben erwähnten Verschiebung des Spannungspotentials des ersten Sternpunktes beim Auftreten eines statischen Erdschlusses zwischen einer der ersten oder der zweiten Phasen und dem Bezugspotential. Das sich ohne einen statischen Erdschluss einstellende Verhältnis der Spannungsbeträge, in dieser Beschreibung auch kurz als "definiertes Spannungsverhältnis" bezeichnet, kann z.B. in einem fehlerfreien ursprünglichen Zustand der Gleichstromnetzes gemessen und als ein Referenztwert in einem Speicher hinterlegt werden, beispielsweise während einer Inbetriebnahme des Netzes. Es ist auch möglich, dass das definierte Spannungsverhältnis aufgrund der bekannten Auslegungswerte des Gleichstromnetzes theoretisch berechnet und als Referenzwert in einem Speicher hinterlegt wird. Sollte zu einem späteren Zeitpunkt ein statischer Erdschluss in dem Gleichstromnetz eintreten, so kann dieser statische Erdschluss durch eine Abweichung des zu dem späteren Zeitpunkt gemessenen Spannungsverhältnisses von dem Referenzwert, d. h. dem ursprünglich vorliegenden, definierten Spannungsverhältnis, detektiert werden. Es ist möglich, dass die Messvorrichtung über eine vorgegebene Zeitspanne in zeitlichen Abständen Messungen von Spannungswerten vornimmt, daraus ein Spannungsverhältnis der Beträge der gemessenen Spannungswerte berechnet und das Ergebnis mit dem Refernzwert, d.h. dem hinterlegten, definierten Spannungsverhältnis, vergleicht; falls der Vergleich eine Abweichung außerhalb eines definierten Toleranzbandes ergibt, schließt die Messvorrichtung auf einen fehlerhaften Stromfluss, hier: einen statischen Erdschluss.

Die Messvorrichtung detektiert also eine Abweichung eines aktuell gemessenen Spannungsverhältnis von einem definierten Spannungsverhältnis, welches einen Refernzwert bildet. In dem speziellen Fall, dass der erste und der zweite Widerstand gleich groß gewählt sind, also den gleichen Widerstandswert aufweisen, ist das ohne einen statischen Erdschluss vorliegende, definierte Spannungsverhältnis gleich Eins, da die Beträge der über dem ersten und dem zweiten Widerstand abfallenden Spannungen gleich groß sind; somit schließt die Messvorrichtung in diesem Spezialfall auf einen statischen Erdschluss, falls die Beträge der über dem ersten und dem zweiten Widerstand abfallenden Spannungen unterschiedlich groß sind, d.h. das Spannungsverhältnis ungleich Eins wird.

Gemäß einer bevorzugten Ausgestaltung der Vorrichtung ist die Messvorrichtung dazu ausgebildet, auf einen statischen Erdschluss zwischen einer der Phasen und dem ersten Sternpunkt zu schließen, wenn der Betrag der Spannung, die über dem mit dieser Phase verbundenen Widerstand abfällt, sich über die Zeit ändert und gegen Null geht. Eine weitere zweckmäßige Ausgestaltung sieht vor, dass die Messvorrichtung dazu ausgebildet ist, auf einen statischen Erdschluss zwischen einer der Phasen und dem ersten Sternpunkt zu schließen, wenn der Betrag der Spannung, die über dem mit dieser Phase verbundenen Widerstand abfällt, Null ist. Kann beispielsweise über dem ersten Widerstand keine Spannung gemessen werden, so kann auf einen Erdschluss zwischen der ersten Phase und dem Bezugspotential geschlossen werden. In diesem Fall fällt über dem zweiten Widerstand die von der Gleichspannungsquelle bereitgestellte Gleichspannung ab. Kann demgegenüber über dem zweiten Widerstand keine Spannung erfasst werden, so kann auf einen Erdschluss zwischen der zweiten Phase und dem Bezugspotential geschlossen werden. In diesem Fall fällt über dem ersten Widerstand die von der Gleichspannungsquelle bereitgestellte Gleichspannung ab.

Gemäß einer bevorzugten Ausgestaltung der Vorrichtung ist die Messvorrichtung dazu ausgebildet, auf einen fehlerhaften Stromfluss von einer der ersten oder zweiten Phase zu dem ersten Sternpunkt zu schließen, wenn der Betrag der Spannung, die über dem mit dieser Phase verbundenen Widerstand abfällt, sich zeitlich ändert. Gemäß einer anderen bevorzugten Ausgestaltung ist die Messvorrichtung dazu ausgebildet, auf einen fehlerhaften Stromfluss von einer der ersten oder zweiten Phase zu dem ersten Sternpunkt zu schließen, wenn der Betrag der Spannung, die über dem mit dieser Phase verbundenen Widerstand abfällt, von einem einem Referenzwert, d.h. einem ohne einen fehlerhaften Stromfluss vorliegenden, definierten Wert, abweicht. Gemäß dieser Ausgestaltung liegt eine Verschiebung des Spannungspotentials am ersten Sternpunkt vor. In Abhängigkeit davon, ob und in welchem Ausmaß die über dem ersten und dem zweiten Widerstand gegenüber dem anderen Widerstand abfallende Spannung größer oder kleiner ist, und unter Berücksichtigung des Verhältnisses der Widerstandswerte des ersten und zweiten Widerstands kann auf einen fließenden Strom von der ersten Phase oder der zweiten Phase gegen Bezugspotential geschlossen werden. In dem speziellen Fall, dass der erste und der zweite Widerstand gleich groß gewählt sind, also einen gleichen Widerstandswert aufweisen, schließt die Messvorrichtung dabei auf einen fehlerhaften Stromfluss von einer der ersten oder zweiten Phase zu dem ersten Sternpunkt, wenn der Betrag der Spannung, die über dem mit dieser Phase verbundenen Widerstand abfällt, kleiner ist als die Spannung, die über dem mit der anderen Phase verbundenen Widerstand abfällt.

Eine weitere zweckmäßige Ausgestaltung sieht vor, dass die Messvorrichtung dazu ausgebildet ist, den Effektivwert der über dem ersten und/oder dem zweiten Widerstand abfallenden Spannung zu ermitteln und beim Überschreiten eines vorgegebenen Schwellwerts auf einen dynamischen Erdschluss zu schließen. Ein dynamischer Erdschluss kann somit erfasst werden, indem aus den erfassten Spannungen Gleichanteile ausgefiltert werden und lediglich die dynamischen Anteile zur Bestimmung der Effektivspannung berücksichtigt werden. Ist kein Fehler vorhanden, so darf keine oder nur eine sehr geringe Effektivspannung vorhanden sein. Der zum Vergleich herangezogene Schwellwert kann durch Versuche oder numerisch bestimmt werden, wobei durch den Schwellwert definiert ist, ab welcher Höhe ein dynamischer Erdschluss vorliegt.

Eine weitere zweckmäßige Ausgestaltung sieht zur Implementierung vor, dass die Messvorrichtung einen ersten Spannungsteiler, der zwischen der ersten Phase und einem zweiten Sternpunkt verschaltet ist, und einen zweiten Spannungsteiler, der zwischen der zweiten Phase und dem zweiten Sternpunkt verschaltet ist, umfasst. Insbesondere umfassen sowohl der erste als auch der zweite Spannungsteiler jeweils eine oder mehrere Schutzimpedanzen und einen Messwiderstand. Die Schutzimpedanzen weisen jeweils einen Widerstandswert auf, der erheblich größer ist als die Widerstandswerte des ersten und des zweiten Widerstands, die mit dem ersten Sternpunkt verbunden sind. Demgegenüber können die Messwiderstände einen wesentlich kleineren Widerstandswert als die Widerstandswerte der Schutzimpedanzen des jeweiligen Spannungsteilers aufweisen.

Gemäß einer weiteren zweckmäßigen Ausgestaltung ist die Messvorrichtung dazu ausgebildet, die Spannungen über den Messwiderständen zu messen und aus dem Verhältnis der gemessenen Spannungen (sog. Messspannung) auf das Vorliegen eines Fehlers zu schließen. Mit Hilfe der Messwiderstände werden die Spannungsverhältnisse an dem ersten und dem zweiten Widerstand des Gleichstromnetzes nachgebildet. Dabei sind die über den Messwiderständen abfallenden Spannungen jedoch deutlich geringer, so dass z.B. auch ein Berührschutz gegeben ist.

In einer weiteren konkreten Ausgestaltung ist vorgesehen, dass die Messvorrichtung dazu ausgebildet ist, die Spannungen über den Messwiderständen zu messen und aus den Beträgen der Spannungen der Messwiderstände auf das Vorliegen eines Erdschlusses zu schließen.

Die Gleichstromanordnung kann zumindest eine Verbrauchsanordnung umfassen, die zwischen der ersten und der zweiten Phase verschaltet ist. Eine solche Verbrauchsanordnung kann z.B. einen Umrichter und einen Wechsel- oder Drehstromverbraucher, wie z.B. einen Motor, umfassen. Grundsätzlich kann die Verbrauchsanordnung auch andere Komponenten umfassen. Eine Verbrauchsanordnung braucht nicht zwingend eine Wechselstrom verarbeitende Komponente aufweisen, jedoch kann mit der hier beschriebenen Messvorrichtung auch auf einen Erdschluss zwischen einer Phase der Wechselstrom verarbeitenden Komponente und dem Bezugspotential geschlossen werden.

Die oben angegebene Aufgabe wird außerdem gelöst durch ein Verfahren gemäß den Merkmalen des Patentanspruches 12. Das Verfahren dient zur Erdschlussüberwachung in einem Gleichstromnetz. Dabei umfasst das Gleichstromnetz eine zwischen einer ersten Phase mit einem positiven Spannungspotential und einer zweiten Phase mit einem negativen Spannungspotential verschaltete Gleichspannungsquelle. Dabei ist die erste Phase über einen ersten Widerstand und die zweite Phase über einen zweiten Widerstand mit einem mit Bezugspotential beaufschlagten ersten Sternpunkt verbunden. Außerdem ist zwischen der ersten Phase und der zweiten Phase zumindest eine Wechsel-oder Drehstrom verarbeitende Verbrauchsanordnung verschaltet. Das Verfahren umfasst dabei folgende Schritte:
Es erfolgt eine Messung der über dem ersten und/oder dem zweiten Widerstand abfallenden Spannungen. Es erfolgt ein Vergleich der gemessenen Spannungen mit mindestens einem Referenzwert, welcher einem fehlerfreien Zustand des Gleichstromnetzes entspricht. Und es wird, abhängig von dem Ergebnis des Vergleichs, ein statischer Erdschluss zwischen einer der Phasen und dem Bezugspotential und/oder ein dynamischer Erdschluss zwischen einer mit Wechselstrom beaufschlagten Phase der Verbrauchsanordnung und dem Bezugspotential detektiert.

Gemäß einer bevorzugten Ausgestaltung des Verfahrens erfolgt eine Auswertung einer Spannungsverteilung über dem ersten und dem zweiten Widerstand. Es wird dabei auf eine Veränderung der Spannungsverteilung geprüft; liegt eine solche Veränderung gegenüber einem Referenzwert, hier: einer sich in einem fehlerfreien Zustand des Gleichstromnetzes einstellenden Spannungsverteilung über dem ersten und dem zweiten Widerstand, vor, so wird auf einen fehlerhaften Stromfluss im Gleichstromnetz, nämlich einen Erdschluss, geschlossen.

Gemäß einer bevorzugten Ausgestaltung des Verfahrens sind der der erste und der zweite Widerstand gleich groß gewählt. In diesem Fall muss zur Erdschlussüberwachung nur darauf geprüft werden, ob die Spannungswerte der über dem ersten und dem zweiten Widerstand abfallenden Spannungen voneinander abweichen. Überschreitet eine Abweichung der beiden Spannungswerte eine definerte Toleranzschwelle, so wird auf einen fehlerhaften Stromfluss im Gleichstromnetz, nämlich einen Erdschluss, geschlossen.

Gemäß einer bevorzugten Ausgestaltung des Verfahrens wird ein statischer Erdschluss detektiert, wenn das Verhältnis der Beträge der über dem ersten und dem zweiten Widerstand abfallenden Spannungen sich zeitlich ändert. Gemäß einer besonders bevorzugten Ausgestaltung des Verfahrens wird ein statischer Erdschluss detektiert, wenn das Verhältnis der Beträge der über dem ersten und dem zweiten Widerstand abfallenden Spannungen von dem Referenzwert, nämlich einem ohne einen statischen Erdschluss vorliegenden Verhältnis, abweicht.

Gemäß einer bevorzugten Ausgestaltung des Verfahrens wird ein statischer Erdschluss zwischen einer der Phasen und dem ersten Sternpunkt detektiert, wenn der Betrag der Spannung, die über dem mit dieser Phase verbundenen Widerstand abfällt, sich zeitlich ändert und gegen Null geht. Gemäß einer besonders bevorzugten Ausgestaltung des Verfahrens wird ein statischer Erdschluss zwischen einer der Phasen und dem ersten Sternpunkt detektiert, wenn der Betrag der Spannung, die über dem mit dieser Phase verbundenen Widerstand abfällt, Null ist.

Gemäß einer bevorzugten Ausgestaltung des Verfahrens wird ein fehlerhafter Stromfluss von einer der ersten oder zweiten Phase zu dem ersten Sternpunkt detektiert, wenn der Betrag der Spannung, die über dem mit dieser Phase verbundenen Widerstand abfällt, sich zeitlich ändert. Gemäß einer besonders bevorzugten Ausgestaltung des Verfahrens wird ein fehlerhafter Stromfluss von einer der ersten oder zweiten Phase zu dem ersten Sternpunkt detektiert, wenn der Betrag der Spannung, die über dem mit dieser Phase verbundenen Widerstand abfällt, von dem Referenzwert, nämlich einem ohne einen fehlerhaften Stromfluss vorliegenden Betrag, abweicht.

Gemäß einer bevorzugten Ausgestaltung des Verfahrens wird der Effektivwert der über dem ersten und/oder dem zweiten Widerstand abfallenden Spannungen ermittelt und beim Überschreiten eines vorgegebenen Schwellwerts auf einen dynamischen Erdschluss geschlossen.

Gemäß einer bevorzugten Ausgestaltung des Verfahrens zur Erdschlussüberwachung erfolgt das Verfahren in einem Gleichstromnetz, welches einen ersten Spannungsteiler, der zwischen der ersten Phase und einem zweiten Sternpunkt verschaltet ist, und einen zweiten Spannungsteiler, der zwischen der zweiten Phase und dem zweiten Sternpunkt verschaltet ist, umfasst, wobei der erste und der zweite Spannungsteiler jeweils eine oder mehrere Schutzimpedanzen und einen Messwiderstand umfasst, wobei das Verfahren eine Messung der Spannungen über den Messwiderständen umfasst, wobei aus dem Verhältnis der Spannungen auf das Vorliegen eines Fehlers geschlossen wird.

Gemäß einer bevorzugten Ausgestaltung des Verfahrens werden die Spannungen über den Messwiderständen gemessen und aus den Beträgen der Spannungen der Messwiderstände auf das Vorliegen eines Erdschlusses geschlossen.

Ein weiterer Aspekt der Erfindung ist ein Computerprogrammprodukt, welches direkt in den internen Speicher einer digitalen Recheneinheit geladen werden kann und welches Softwarecodeabschnitte umfasst, mit denen die Schritte des Verfahrens ausgeführt werden, wenn das Produkt auf der Recheneinheit läuft.

Weitere Merkmale der Erfindung werden nachfolgend in Verbindung mit der Beschreibung eines Ausführungsbeispiels in der Zeichnung erläutert. Es zeigen:

Fig. 1    eine schematische Darstellung eines elektrischen Ersatzschaltbildes eines Gleichstromnetzes; und

Fig. 2    eine schematische Darstellung eines elektrischen Ersatzschaltbildes einer Vorrichtung zur Erd-schlussüberwachung in dem Gleichstromnetz aus Fig. 1.

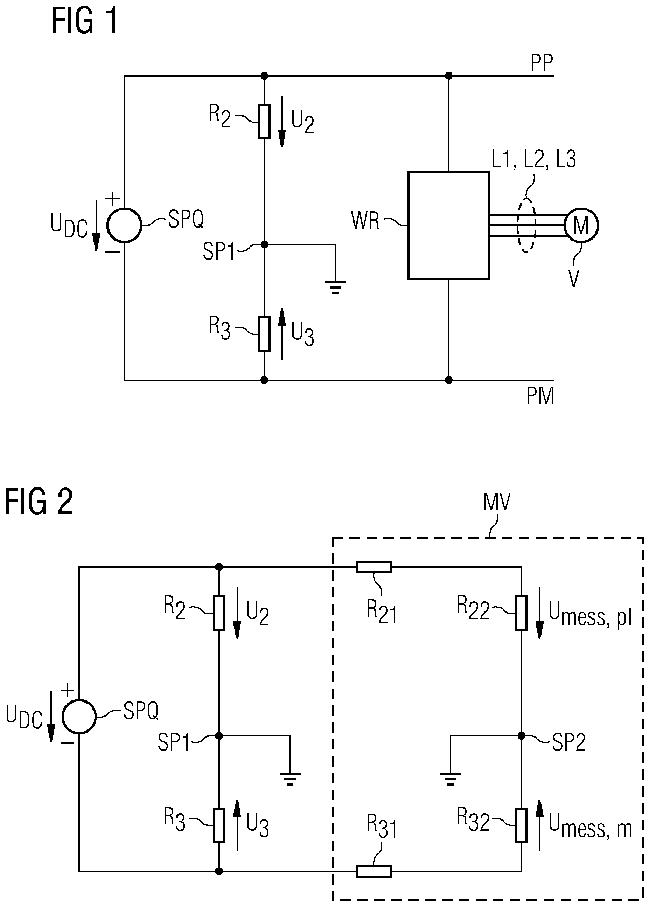

Fig. 1 zeigt ein elektrisches Ersatzschaltbild eines bekannten Gleichstromnetzes. Das Gleichstromnetz umfasst eine erste Phase PP mit einem positiven Spannungspotential und eine zweite Phase PM mit einem negativen Spannungspotential. Zwischen der ersten Phase PP und der zweiten Phase PM ist eine Gleichspannungsquelle SPQ verschaltet, welche die erste und die zweite Phase PP, PM mit dem positiven bzw. negativen Spannungspotential beaufschlagt.

Zur Realisierung einer definierten Impedanz zu einem Bezugspotential (Erde) ist die erste Phase PP über einen ersten Widerstand $R_2$ mit einem ersten Sternpunkt SP1, der mit dem Bezugspotential (Erde) beaufschlagt ist, verbunden. In entsprechender Weise ist die zweite Phase PM über einen zweiten Widerstand $R_3$ mit dem ersten Sternpunkt SP1 verbunden. Der erste und der zweite Widerstand $R_2$, $R_3$ weisen in diesem Ausführungsbeispiel einen gleichen Widerstandswert auf, so dass die über dem ersten und dem zweiten Widerstand $R_2$, $R_3$ abfallenden Spannungen $U_2$ und $U_3$ betragsmäßig gleich groß sind, d.h. $U_2 = -U_3$. Anders ausgedrückt, verteilt sich dabei die von der Gleichspannungsquelle SPQ bereitgestellte Spannung $U_{DC}$ gleich über den zweiten und den dritten Widerstand $R_2$, $R_3$ auf, d.h. $U_{DC} = U_2 - U_3$.

Das Gleichstromnetz kann beispielsweise zur Stromversorgung einer industriellen Anlage dienen. Als Verbrauchsanordnung ist beispielhaft ein Umrichter WR dargestellt, der zwischen der ersten Phase PP und der zweiten Phase PM verschaltet ist. An den Ausgang des Umrichters WR ist ein lediglich beispielhaft dreiphasiger Verbraucher V in Gestalt eines Motors M angeschlossen. Die Phasen sind in Fig. 1 mit L1, L2 und L3 gekennzeichnet. Es ist anzumerken, dass die in Fig. 1 gezeigte Verbrauchsanordnung, die den Umrichter WR und den Verbraucher V umfasst, lediglich beispielhaft einen dreiphasigen Verbraucher V umfasst.

In einem wie in Fig. 1 gezeigten Gleichstromnetz können als Erdschlüsse ein statischer Erdschluss oder ein dynamischer Erdschluss auftreten.

Bei einem statischen Erdschluss besteht beispielsweise eine Verbindung zwischen der ersten Phase PP und dem Bezugspotential (Erde) oder zwischen der zweiten Phase PM und dem Bezugspotential (Erde).

Bei einem dynamischen Erdschluss besteht eine fehlerhafte Verbindung zwischen einer der Phasen L1, L2, L3 zum Bezugspotential (Erde). Dieser dynamische Erdschluss ergibt sich z.B. dadurch, dass der Umrichter WR aus der Gleichspannung $U_{DC}$ mit Hilfe von nicht näher dargestellten Schaltelementen (in der Regel Halbleiterschaltelemente, wie z.B. Feldeffekttransistoren oder IGBTs) eine sinusähnliche Wechselspannung erzeugt. Tritt nun in einem der Schaltelemente ein Kurzschluss oder ein Leerlauf auf, d.h. das entsprechende Schaltelement des Umrichters wird nicht mehr leitend, so ergeben sich sinus-oder halbsinusähnliche Verfälschungen der Gleichspannung gegenüber dem Bezugspotential.

Diese beiden Arten von Erdschlüssen können mit Hilfe der nachfolgend beschriebenen Messvorrichtung erfasst werden.

Zur Beschreibung des Aufbaus und der Funktionsweise der erfindungsgemäß vorgesehenen Messvorrichtung MV wird auf Fig. 2 verwiesen, wobei der Einfachheit halber die Verbrauchsanordnung aus Fig. 1 nicht mehr dargestellt ist.

Die Messvorrichtung MV umfasst einen ersten Spannungsteiler, der zwischen der ersten Phase PP und einem zweiten Sternpunkt SP2 verschaltet ist, sowie einen zweiten Spannungsteiler, der zwischen der zweiten Phase PM und dem zweiten Sternpunkt SP2 verschaltet ist. Der erste Spannungsteiler umfasst eine erste Schutzimpedanz $R_{21}$ sowie einen ersten Messwiderstand $R_{22}$. Die erste Schutzimpedanz $R_{21}$ ist mit dem Knotenpunkt zwischen der Gleichspannungsquelle SPQ und dem ersten Widerstand $R_2$ verbunden. Der erste Messwiderstand $R_{22}$ ist mit dem zweiten Sternpunkt SP2 verbunden. Der zweite Spannungsteiler umfasst eine zweite Schutzimpedanz $R_{31}$ und einen zweiten Messwiderstand $R_{32}$. Die zweite Schutzimpedanz $R_{31}$ ist mit dem Knotenpunkt des zweiten Widerstands $R_3$ und der Gleichspannungsquelle SPQ verbunden. Der zweite Messwiderstand $R_{32}$ ist mit dem zweiten Sternpunkt SP2 verbunden. Der zweite Sternpunkt SP2 ist mit dem Bezugspotential (Erde) beaufschlagt.

Die Widerstandswerte der Schutzimpedanzen $R_{21}$ und $R_{31}$ sind gleich groß. In entsprechender Weise sind die Widerstandswerte der Messwiderstände $R_{22}$ und $R_{32}$ ebenfalls gleich groß. Der Widerstandsteiler ist somit symmetrisch aufgebaut, d.h. die Messimpedanzen sind jeweils identisch, ebenso wie die Messwiderstände jeweils identisch sind.

Die Widerstandswerte der Schutzimpedanzen $R_{21}$ und $R_{31}$ sind sehr viel größer als die Widerstandswerte des ersten und des zweiten Widerstands $R_2$, $R_3$, um eine Personenschutzfunktion zu übernehmen. Demgegenüber sind die Messwiderstände $R_{22}$ und $R_{32}$ wesentlich kleiner, um über die Messwiderstände $R_{22}$, $R_{32}$ erfasste Spannungen $U_{mess,pl}$ und $U_{mess,m}$ auf niedrigerem Spannungsniveau erfassen zu können.

In dem in Fig. 2 gezeigten Ausführungsbeispiel ist der Mittelpunkt zwischen den beiden Messwiderständen $R_{22}$ und $R_{32}$ mit dem Bezugspotential verbunden, d. h. geerdet. Wenn dieser Sternpunkt SP2 nicht geerdet ist, wird anstelle der über den Messwiderständen $R_{22}$ und $R_{32}$ erfassten Messspannungen $U_{mess,pl}$ und $U_{mess,m}$ die Spannung zwischen diesem Sternpunkt und einem Bezugspotential gemessen.

Die Messeinrichtung MV ist dazu eingerichtet, mittels einer nicht näher dargestellten Mess- und Auswerteeinheit die Spannungen $U_{mess,pl}$ und $U_{mess,m}$ zu erfassen und die Spannungsverteilung auszuwerten. Aufgrund des symmetrisch aufgebauten Widerstandsteilers entspricht das Spannungsverhältnis der Messwiderstände $R_{22}$ und $R_{32}$ der Spannungsverteilung des ersten und des zweiten Widerstandes $R_2$ und $R_3$ zur Realisierung der hochohmigen Erde.

Liegt kein statischer Fehler vor, so gilt:

$$U_{DC} = (U_{mess,pl} - U_{mess,m}) \times k$$

wobei k ein konstanter Faktor ist, der sich aus dem Verhältnis der Widerstandswerte der beiden Spannungsteiler ergibt. Die Dimensionierung der Widerstandswerte und damit des Faktors k hängen von verschiedenen Faktoren ab. Um die "internen Schutzimpedanzen" nicht zu verfälschen, sollten die Widerstandswerte entsprechend groß gewählt werden. Bei Anforderungen an den Personenschutz für das Messgerät sind die Widerstandswerte so zu wählen, dass innerhalb der Mess-Schaltung keine lebensgefährlichen Ströme auftreten können. Werden die Widerstandwerte zu groß gewählt, so wirkt die Schaltung wegen der parasitären Effekte als Tiefpass, d.h. je größer der Frequenzanteil, desto geringer wird dieser Anteil gemessen. Höhere Frequenzanteile werden dann eventuell zu gering oder gar nicht erfasst.

Wenn kein statischer Fehler vorliegt, gilt außerdem:

$$U_{mess,pl} = -U_{mess,m} \text{ bzw. } U_2 = -U_3.$$

Tritt ein statischer Fehler auf, so verändert sich die von der Gleichspannungsquelle SPQ gelieferte Spannung $U_{DC}$ nicht. Damit bleibt jedoch auch die Differenz $U_2$-$U_3$ gleich. Allerdings sind die Beträge der Spannungen $U_2$ und $U_3$ in Abhängigkeit des Fehlers unterschiedlich, d.h. es gilt:

$$U_2 \neq -U_3,$$

was durch $U_{mess,pl} \neq -U_{mess,m}$ detektierbar ist.

Dies bedeutet, die über den Messwiderständen $R_{22}$ und $R_{33}$ gemessenen Messspannungen $U_{mess,pl}$ und $U_{mess,m}$ sind dem Betrag nach nicht mehr gleich, es entsteht eine Unsymmetrie. Das Maß der Unsymmetrie gibt Aufschluss über das Vorliegen des Fehlers. Wenn $U_2 = 0$ bzw. $U_{mess,pl} = 0$ sind, so liegt ein Erdschluss zwischen der ersten Phase PP und dem Bezugspotential vor. Wenn $U_3 = 0$ bzw. $U_{mess,m} = 0$ sind, so liegt ein Erdschluss zwischen der zweiten Phase PM und dem Bezugspotential vor. Ist der Betrag der Spannung $U_2$ kleiner als der Betrag der Spannung $U_3$, d.h. ist die Messspannung $U_{mess,pl}$ kleiner als $U_{mess,m}$, so fließt ein Strom von der ersten Phase PP gegen das Bezugspotential (Erdpotential). Ist der Betrag der Spannung $U_2$ größer als der Betrag der Spannung $U_3$, d.h. ist die Messspannung $U_{mess,pl}$ größer als $U_{mess,m}$, so fließt ein Strom von der zweiten Phase PM gegen das Bezugspotential (Erdpotential).

Ein dynamischer Erdschluss kann erfasst werden, indem die Messspannungen $U_{mess,pl}$ und/oder $U_{mess,m}$ derart verarbeitet werden, dass Gleichanteile ausgefiltert werden und lediglich die dynamischen Anteile in Form der Effektivspannung gemessen werden. Liegt in der einen Wechselstrom verarbeitenden Verbrauchsanordnung WR, V kein Fehler vor, so dürfen keine bzw.

nur geringe Wechselspannungsanteile in der Messung vorhanden sein. Durch die Vorgabe einer durch Versuche oder numerisch bestimmten Schwelle kann festgelegt werden, ab welcher ein kritischer dynamischer Erdschluss vorliegt.

Durch die kombinatorische Messung der statischen und dynamischen Anteile kann somit in dem Gleichstromnetz ein Erdschluss erfasst und ausgewertet werden.

Es ist an dieser Stelle explizit noch einmal darauf hinzuweisen, dass, abweichend von dem in den Figuren 1 und 2 erläuterten, besonders einfach auszuwertenden symmetrischen Spezialfall, bei dem die Widerstandswerte des ersten und des zweiten Widerstands $R_2$, $R_3$, die Widerstandswerte der ersten und der zweiten Schutzimpedanz $R_{21}$ und $R_{31}$ und die Widerstandswerte des ersten und des zweiten Messwiderstands $R_{22}$ und $R_{32}$ jeweils gleich groß gewählt werden, diese Widerstands- bzw. Impedanzpaare auch jeweils unterschiedlich groß gewählt werden können. In diesem allgemeineren Fall muss die Messvorrichtung auswerten, ob die aktuell gemessenen Spannungsverhältnisse $U_{mess,pl}$ / $U_{mess,m}$ bzw. $U_2$ / $U_3$ von ursprünglich vorliegenden, sich ohne einen fehlerhaften Stromfluss einstellenden Verhältnissen abweichen.

**Patentansprüche**

1. Vorrichtung zur Erdschlussüberwachung in einem Gleichstromnetz, wobei das Gleichstromnetz eine zwischen einer ersten Phase (PP) mit einem positiven Spannungspotential und einer zweiten Phase (PM) mit einem negativen Spannungspotential verschaltete Gleichspannungsquelle (SPQ) umfasst, wobei die erste Phase (PP) über einen ersten Widerstand ($R_2$) und die zweite Phase (PM) über einen zweiten Widerstand ($R_3$) mit einem mit Bezugspotential beaufschlagten ersten Sternpunkt (SP1) verbunden sind, und wobei zwischen der ersten Phase (PP) und der zweiten Phase (PM) zumindest eine Wechsel- oder Drehstrom verarbeitende Verbrauchsanordnung (WR, V) verschaltet ist, umfassend:
   eine Messvorrichtung (MV), die dazu ausgebildet ist, einen statischen Erdschluss zwischen einer der Phasen (PP, PM) und dem Bezugspotential und/oder einen dynamischen Erdschluss zwischen einer mit Wechselstrom beaufschlagten Phase (L1, L2, L3) der Verbrauchsanordnung (WR, V) und dem Bezugspotential zu detektieren durch Messung der über dem ersten und dem zweiten Widerstand ($R_2$, $R_3$) abfallenden Spannung und Auswertung einer Spannungsverteilung über dem ersten und dem zweiten Widerstand ($R_2$, $R_3$).

2. Vorrichtung nach Anspruch 1, bei der der erste und der zweite Widerstand ($R_2$, $R_3$) gleich groß sind.

**3.** Vorrichtung nach einem der vorhergehenden Ansprüche, bei der die Messvorrichtung (MV) dazu ausgebildet ist, auf einen statischen Erdschluss zu schließen, wenn das Verhältnis der Beträge der über dem ersten und dem zweiten Widerstand ($R_2$, $R_3$) abfallenden Spannungen von dem ohne einen statischen Erdschluss vorliegenden Verhältnis abweicht.

**4.** Vorrichtung nach einem der vorhergehenden Ansprüche, bei der die Messvorrichtung (MV) dazu ausgebildet ist, auf einen statischen Erdschluss zwischen einer der Phasen (PP, PM) und dem ersten Sternpunkt (SP1) zu schließen, wenn der Betrag der Spannung, die über dem mit dieser Phase verbundenen Widerstand ($R_2$, $R_3$) abfällt, Null ist.

**5.** Vorrichtung nach einem der vorhergehenden Ansprüche, bei der die Messvorrichtung (MV) dazu ausgebildet ist, auf einen fehlerhaften Stromfluss von einer der ersten oder zweiten Phase (PP, PM) zu dem ersten Sternpunkt (SP1) zu schließen, wenn der Betrag der Spannung, die über dem mit dieser Phase verbundenen Widerstand ($R_2$, $R_3$) abfällt, von dem ohne einen fehlerhaften Stromfluss vorliegenden Betrag abweicht.

**6.** Vorrichtung nach einem der vorhergehenden Ansprüche, bei der die Messvorrichtung (MV) dazu ausgebildet ist, den Effektivwert der über dem ersten und/oder dem zweiten Widerstand ($R_2$, $R_3$) abfallenden Spannungen zu ermitteln und beim Überschreiten eines vorgegebenen Schwellwerts auf einen dynamischen Erdschluss zu schließen.

**7.** Vorrichtung nach einem der vorhergehenden Ansprüche, bei der die Messvorrichtung (MV) einen ersten Spannungsteiler, der zwischen der ersten Phase (PP) und einem zweiten Sternpunkt (SP2) verschaltet ist, und einen zweiten Spannungsteiler, der zwischen der zweiten Phase (PM) und dem zweiten Sternpunkt (SP2) verschaltet ist, umfasst.

**8.** Vorrichtung nach Anspruch 7, bei der der erste und der zweite Spannungsteiler jeweils eine oder mehrere Schutzimpedanzen ($R_{21}$, $R_{31}$) und einen Messwiderstand ($R_{22}$, $R_{32}$) umfasst.

**9.** Vorrichtung nach Anspruch 8, bei der die Messvorrichtung (MV) dazu ausgebildet ist, die Spannungen über den Messwiderständen ($R_{22}$, $R_{32}$) zu messen und aus dem Verhältnis der Spannungen ($U_{mess,pl}$, $U_{mess,m}$) auf das Vorliegen eines Fehlers zu schließen.

**10.** Vorrichtung nach Anspruch 8 oder 9, bei der die Messvorrichtung (MV) dazu ausgebildet ist, die Spannungen über den Messwiderständen ($R_{22}$, $R_{32}$)

zu messen und aus den Beträgen der Spannungen der Messwiderstände ($R_{22}$, $R_{32}$) auf das Vorliegen eines Erdschlusses zu schließen.

**11.** Vorrichtung nach einem der vorhergehenden Ansprüche, bei der die Verbrauchsanordnung einen Umrichter (WR) und einen Wechselstromverbraucher (V) umfasst.

**12.** Verfahren zur Erdschlussüberwachung in einem Gleichstromnetz, wobei das Gleichstromnetz eine zwischen einer ersten Phase (PP) mit einem positiven Spannungspotential und einer zweiten Phase (PM) mit einem negativen Spannungspotential verschaltete Gleichspannungsquelle (SPQ) umfasst, wobei die erste Phase (PP) über einen ersten Widerstand ($R_2$) und die zweite Phase (PM) über einen zweiten Widerstand ($R_3$) mit einem mit Bezugspotential beaufschlagten ersten Sternpunkt (SP1) verbunden sind, und wobei zwischen der ersten Phase (PP) und der zweiten Phase (PM) zumindest eine Wechsel- oder Drehstrom verarbeitende Verbrauchsanordnung (WR, V) verschaltet ist, das Verfahren umfassend folgende Schritte:

- Messung der über dem ersten und/oder dem zweiten Widerstand ($R_2$, $R_3$) abfallenden Spannungen;
- Vergleich der gemessenen Spannungen mit mindestens einem Referenzwert, welcher einem fehlerfreien Zustand des Gleichstromnetzes entspricht; und
- abhängig von dem Ergebnis des Vergleichs, Detektion eines statischen Erdschlusses zwischen einer der Phasen (PP, PM) und dem Bezugspotential und/oder eines dynamischen Erdschlusses zwischen einer mit Wechselstrom beaufschlagten Phase (L1, L2, L3) der Verbrauchsanordnung (WR, V) und dem Bezugspotential.

**13.** Computerprogrammprodukt, das direkt in den internen Speicher einer digitalen Recheneinheit geladen werden kann und Softwarecodeabschnitte umfasst, mit denen die Schritte gemäß Anspruch 12 ausgeführt werden, wenn das Produkt auf der Recheneinheit läuft.

# FIG 1

# FIG 2

**Europäisches Patentamt**
**European Patent Office**
**Office européen des brevets**

# EUROPÄISCHER RECHERCHENBERICHT

**Nummer der Anmeldung**

EP 18 17 8800

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| X | DE 10 2006 031663 B3 (SEMIKRON ELEKTRONIK GMBH [DE]) 15. November 2007 (2007-11-15) * das ganze Dokument * ----- | 1-13 | INV. H02H3/16 G01R27/18 G01R31/02 |
| X | DE 10 2015 108024 A1 (FORD GLOBAL TECH LLC [US]) 3. Dezember 2015 (2015-12-03) * Absätze [0017], [0018]; Abbildung 1 * ----- | 1-5,12, 13 | |

**RECHERCHIERTE SACHGEBIETE (IPC)**

H02H
G01R

Der vorliegende Recherchenbericht wurde für alle Patentansprüche erstellt

| Recherchenort | Abschlußdatum der Recherche | Prüfer |
|---|---|---|
| München | 9. Januar 2019 | Trifonov, Antoniy |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus anderen Gründen angeführtes Dokument

        ....................................................................
& : Mitglied der gleichen Patentfamilie, übereinstimmendes Dokument

EPO FORM 1503 03.82 (P04C03)

**ANHANG ZUM EUROPÄISCHEN RECHERCHENBERICHT
ÜBER DIE EUROPÄISCHE PATENTANMELDUNG NR.**

EP 18 17 8800

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

09-01-2019

| Im Recherchenbericht angeführtes Patentdokument | Datum der Veröffentlichung | Mitglied(er) der Patentfamilie | Datum der Veröffentlichung |
|---|---|---|---|
| DE 102006031663 B3 | 15-11-2007 | CN 101101310 A | 09-01-2008 |
| | | DE 102006031663 B3 | 15-11-2007 |
| | | EP 1876455 A1 | 09-01-2008 |
| | | JP 5250220 B2 | 31-07-2013 |
| | | JP 2008014945 A | 24-01-2008 |
| | | KR 20080005327 A | 11-01-2008 |
| | | US 2008007277 A1 | 10-01-2008 |
| DE 102015108024 A1 | 03-12-2015 | CN 105301424 A | 03-02-2016 |
| | | DE 102015108024 A1 | 03-12-2015 |
| | | US 2015346257 A1 | 03-12-2015 |

EPO FORM P0461

Für nähere Einzelheiten zu diesem Anhang : siehe Amtsblatt des Europäischen Patentamts, Nr.12/82